# EUROPEAN PATENT SPECIFICATION

(11) **EP 4 498 592 B1**
(45) Date of publication and mention of the grant of the patent: **22.04.2026**
(21) Application number: 23795847.5
(22) Date of filing: 08.02.2023
(51) Int. Cl.: H02M 7/00, H01L 25/07, H01L 23/60, H01L 23/498

(54) **POWER MODULE AND POWER CONVERSION DEVICE**
LEISTUNGSMODUL UND LEISTUNGSUMWANDLUNGSVORRICHTUNG
MODULE DE PUISSANCE ET DISPOSITIF DE CONVERSION DE PUISSANCE

(30) Priority: 28.04.2022 JP 2022075437
(43) Date of publication of application: 29.01.2025
(73) Proprietor: Mitsubishi Heavy Industries, Ltd., Tokyo 100-8332 (JP)
(72) Inventor: EZUMI, Masahiko, Tokyo 100-8332 (JP)
(74) Representative: Studio Torta S.p.A.
(86) International application number: PCT/JP2023/004097
(87) International publication number: WO 2023/210099

(56) References cited:
- WO-A1-2013/157066
- DE-A1- 102018 213 987
- JP-A- 2020 124 071
- JP-A- 2020 143 594
- US-A1- 2020 058 600

## Description

The present disclosure relates to a power module and a power conversion device.

Priority is claimed on Japanese Patent Application No. 2022-75437, filed April 28, 2022.

### Background Art

Patent Document 1, for example, discloses a power semiconductor module (power module) in which a groove portion is formed between terminal block portions on which main circuit terminals are disposed.

The groove portion secures a creepage distance between the main circuit terminals and, as a result, the module is made compact in size while securing an insulation distance compliant with international standards.

Insulation distance is composed of two elements: a creepage distance and a clearance distance.

Patent Documents 2 and 3 also disclose power semiconductor modules. In particular, Patent Document 2 discloses a power module comprising: a main terminal portion including a first conductor including a P terminal at one end of the first conductor, the P terminal including a first main surface and a first back surface facing a side opposite to the first main surface, and a second conductor including an N terminal at one end of the second conductor, the N terminal including a second main surface facing a direction identical to a direction in which the first main surface faces and a second back surface facing a side opposite to the second main surface, the second conductor being connected to a capacitor together with the first conductor and being arranged side by side with the first conductor with a gap interposed between the second conductor and the first conductor; a circuit board including a power semiconductor element configured to convert a DC voltage from the main terminal portion into an AC voltage; an output terminal portion configured to output an AC voltage from the power semiconductor element; a pair of fastening portions connecting the P terminal and a positive-electrode-side terminal of the capacitor to each other and connecting the N terminal and a negative-electrode-side terminal of the capacitor to each other; a base plate to which the circuit board is fixed, the base plate including a front surface facing the first back surface and the second back surface; a case fixed to the front surface of the base plate and accommodating the P terminal, the N terminal, and the pair of fastening portions.

### Citation List

### Patent Literature

Patent Document 1: JP 2012-5301 A
Patent Document 2: US 2020/0058600 A1
Patent Document 3: DE 10 2018 213987 A1

### Summary of Invention

### Technical Problem

In the field of power modules, even if the creepage distance between terminals is secured by a groove, it is necessary to secure the clearance distance between the terminals according to a magnitude of a voltage applied to the terminals.

Securing the insulation distance therefore makes it necessary to increase the clearance distance according to the voltage applied to the terminal.

This may, as a result, increase the size of the power module.

The present disclosure has been made to solve the problem described above, and an object of the present disclosure is to provide a power module and a power conversion device in which an increase in size can be suppressed.

### Solution to Problem

To solve the problem described above, a power module according to the present invention is presented in claim 1. The power module according to claim 1 includes a main terminal portion including a first conductor including a P terminal at one end of the first conductor, the P terminal including a first main surface and a first back surface facing a side opposite to the first main surface, and a second conductor including an N terminal at one end of the second conductor, the N terminal including a second main surface facing a direction identical to a direction in which the first main surface faces and a second back surface facing a side opposite to the second main surface, the second conductor being connected to a capacitor together with the first conductor and being arranged side by side with the first conductor with a gap interposed between the second conductor and the first conductor; a circuit board including a power semiconductor element configured to convert a DC voltage from the main terminal portion into an AC voltage; an output terminal portion configured to output an AC voltage from the power semiconductor element; a pair of fastening portions connecting the P terminal and a positive-electrode-side terminal of the capacitor to each other and connecting the N terminal and a negative-electrode-side terminal of the capacitor to each other; a base plate to which the circuit board is fixed, the base plate including a front surface facing the first back surface and the second back surface; a case fixed to the front surface of the base plate and including an accommodation space accommodating the P terminal, the N terminal, and the pair of fastening portions; and a first insulating portion disposed in the accommodation space and covering the first main surface, the second main surface, and the pair of fastening portions from a side opposite to the base plate, in a state of the gap being filled with the first insulating portion.

A power conversion device according to the present invention includes the power module described above, the capacitor, and a second insulating portion formed integrally with the positive-electrode-side terminal and the negative-electrode-side terminal so as to extend from the first insulating portion, and covering the positive-electrode-side terminal and the negative-electrode-side terminal from an outer side.

### Advantageous Effects of Invention

According to the present invention, it is possible to provide a power module and a power conversion device in which an increase in size can be suppressed.

### Brief Description of Drawings

FIG. 1 is a perspective view illustrating a schematic configuration of a power conversion device according to an embodiment of the present invention.
FIG. 2 is a plan view of a power module according to a first embodiment of the present invention in plan view.
FIG. 3 is a cross-sectional view taken along line III-III in FIG. 2.
FIG. 4 is a cross-sectional view of the power module according to a second embodiment of the present invention, which corresponds to the portion illustrated in FIG. 3.
FIG. 5 is a cross-sectional view of the power module according to a third embodiment of the present invention, which corresponds to the portion illustrated in FIG. 4.
Further, FIG. 5 is a cross-sectional view taken along line V-V illustrated in FIG. 6.
FIG. 6 is a view of the power module according to the third embodiment of the present invention in plan view.

### Description of Embodiments

Hereinafter, embodiments for implementing a power conversion device according to the present invention will be described with reference to the accompanying drawings.

### First Embodiment

### Power Conversion Device

A power conversion device is a device that converts DC power into three-phase AC power or the like.

Examples of the power conversion device of the present embodiment include an inverter used in a system of a power plant or the like, and an inverter used for driving an electric motor of an electric vehicle or the like.

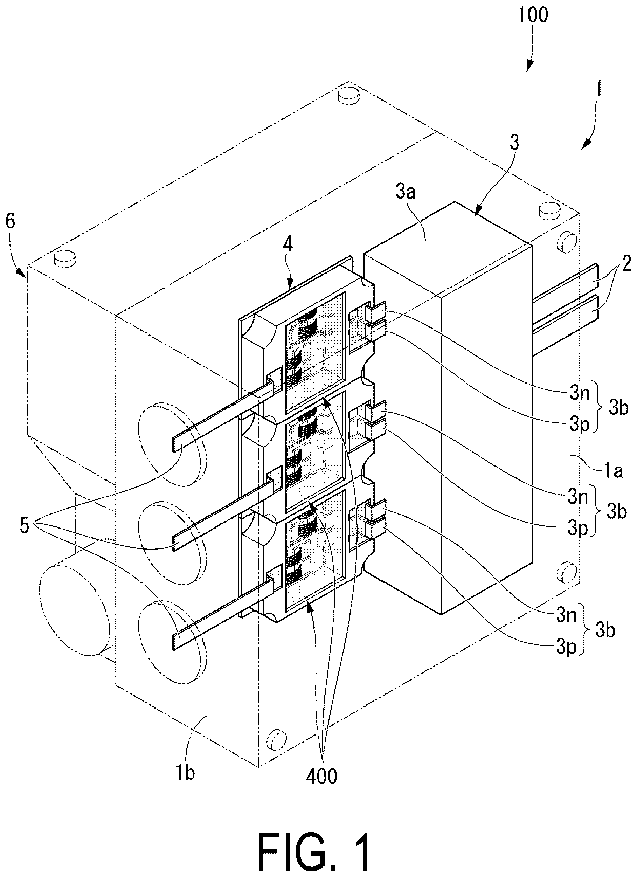

As illustrated in FIG. 1, a power conversion device 100 includes a casing 1, an external input conductor 2, a capacitor 3, a power conversion unit 4, an external output conductor 5, and a cooling device 6.

### Casing

The casing 1 forms an outer shell of the power conversion device 100.

The casing 1 in the present embodiment is formed of a metal such as aluminum, a synthetic resin, or the like, and has a rectangular parallelepiped shape.

The casing 1 includes two side surfaces disposed back to back.

Hereinafter, of these two side surfaces, the side surface facing one side is referred to as an input-side side surface 1a, and the side surface facing the other side is referred to as an output-side side surface 1b.

An external input conductor 2 for inputting DC power is led out from the input-side side surface 1a.

### External Input Conductor

The external input conductor 2 is a pair of electrical conductors (busbars) that supply DC power supplied from a power grid or the like outside the power conversion device 100 to the capacitor.

The external input conductor 2 in the present embodiment is formed of a metal containing copper or the like.

One end of the external input conductor 2 is connected to the capacitor 3, and the other end of the external input conductor 2 extends in a direction intersecting the input-side side surface 1a of the casing 1.

### Capacitor

The capacitor 3 is a smoothing capacitor for storing electric charge input from the external input conductor 2 and suppressing voltage fluctuation associated with power conversion.

The DC voltage input from the external input conductor 2 is supplied to the power conversion unit 4 via the capacitor 3.

The capacitor 3 includes a main body portion 3a and a connection conductor 3b.

The main body portion 3a is a portion that mainly exhibits the function of the smoothing capacitor described above.

The connection conductor 3b is an electrical conductor (busbar) for transmitting power from the main body portion 3a to the power conversion unit 4.

The connection conductor 3b is formed of a metal such as copper.

The connection conductor 3b has a positive-electrode-side terminal 3p and a negative-electrode-side terminal 3n.

The positive-electrode-side terminal 3p forms a positive electrode of the capacitor 3 and is a current path connecting the main body portion 3a and a positive electrode of a power module 400.

The negative-electrode-side terminal 3n forms a negative electrode of the capacitor 3 and is a current path connecting the main body portion 3a and a negative electrode of the power module 400.

The positive-electrode-side terminal 3p and the negative-electrode-side terminal 3n are disposed side by side at an interval.

One end of each of the positive-electrode-side terminal 3p and the negative-electrode-side terminal 3n is connected to the main body portion 3a.

Note that a detailed illustration of a connected state between the positive-electrode-side terminal 3p and the negative-electrode-side terminal 3n and the main body portion 3a is omitted.

The other end of each of the positive-electrode-side terminal 3p and the negative-electrode-side terminal 3n is connected to the power module 400.

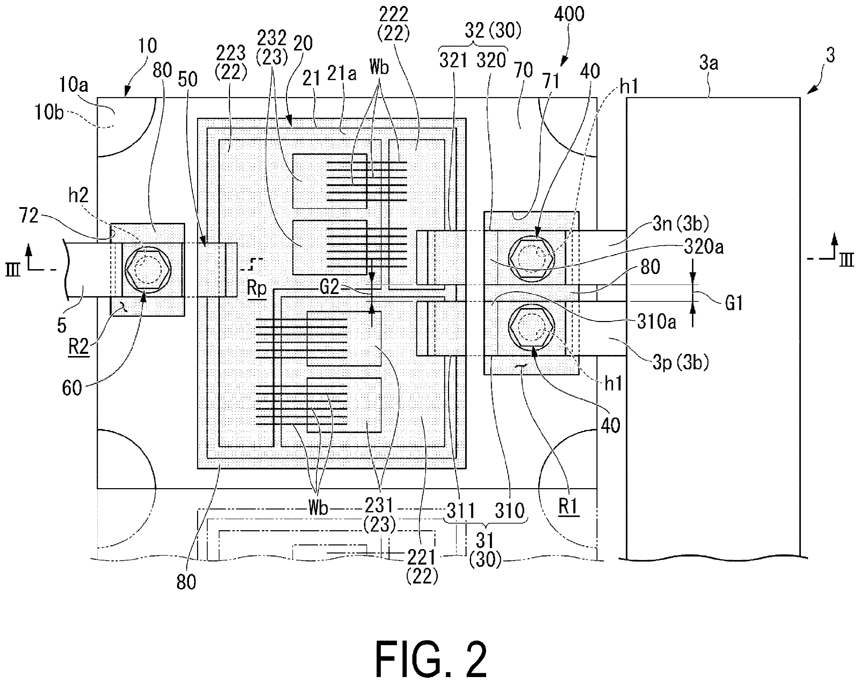

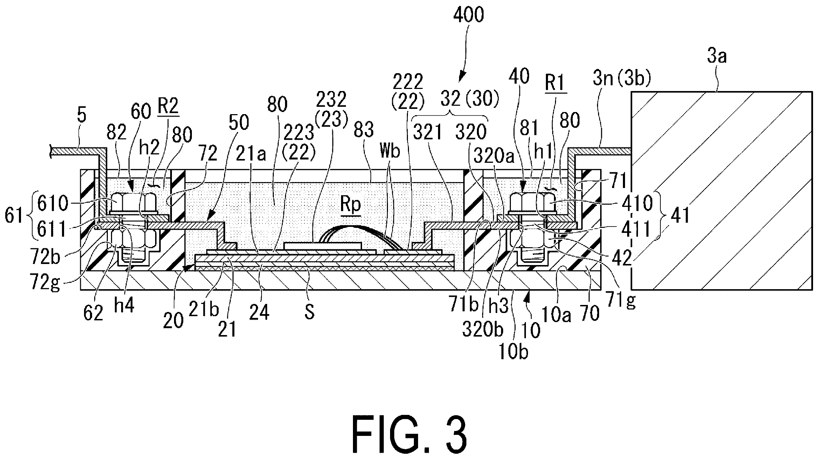

As illustrated in FIG. 2 and FIG. 3, fastening holes h1 are formed in the positive-electrode-side terminal 3p and the negative-electrode-side terminal 3n.

Hereinafter, the interval that occurs between the positive-electrode-side terminal 3p and the negative-electrode-side terminal 3n by the two being disposed side by side is referred to as a gap G1.

In other words, the negative-electrode-side terminal 3n is arranged side by side with the positive-electrode-side terminal 3p with the gap G1 interposed therebetween.

A clearance distance (isolation distance) is secured by the gap G1 so that discharge does not occur between the positive-electrode-side terminal 3p and the negative-electrode-side terminal 3n due to a potential difference generated between the positive-electrode-side terminal 3p and the negative-electrode-side terminal 3n.

The clearance distance in the present embodiment is desirably, for example, from 1 mm to 10 mm.

### Power Conversion Unit

As illustrated in FIG. 1, the power conversion unit 4 converts the voltage input from the capacitor 3.

In order to output three-phase AC power, the power conversion unit 4 in the present embodiment includes three power modules 400 respectively responsible for outputs for a U phase, a V phase, and a W phase.

Accordingly, the power conversion device 100 in the present embodiment is a three-phase inverter including the three power modules 400.

A configuration of the power module 400 will be described in detail below.

### External Output Conductor

The external output conductor 5 is an electrical conductor (busbar) that supplies the AC power converted by the power conversion unit 4 to a device provided outside the power conversion device 100.

The power conversion device 100 in the present embodiment includes three external output conductors 5 for the U phase, the V phase, and the W phase, and one of these external output conductors 5 is provided in each power module 400.

The external output conductor 5 in the present embodiment is formed of a metal containing copper or the like.

One end of each external output conductor 5 is connected to the power module 400, and the other end of each external output conductor 5 extends in a direction intersecting the output-side side surface 1b of the casing 1.

As illustrated in FIG. 2 and FIG. 3, a fastening hole h2 is formed in one end side (power module 400 side) of the external output conductor 5.

Note that wiring or a terminal (not illustrated) for current output, for example, is connected to the other end side of the external output conductor 5.

This makes it possible to output AC power to outside the power conversion device 100.

### Cooling Device

As illustrated in FIG. 1, the cooling device 6 is a device that mainly cools the power module 400 of the power conversion unit 4.

The cooling device 6 is provided layered on the casing 1, and is fixed to and integrated with the casing 1.

A liquid coolant such as water, for example, is introduced into the cooling device 6 from the outside.

This liquid coolant cools the power module 400 by performing heat exchange with the power module 400 and being heated.

Hereinafter, a configuration of the power module 400 included in the power conversion unit 4 according to the present embodiment will be described.

### Power Module

The power module 400 is a device that converts input power and outputs the converted power.

The power module 400 in the present embodiment constitutes part of the power conversion unit 4.

As illustrated in FIG. 2 and FIG. 3, the power module 400 includes a base plate 10, a circuit board 20, a main terminal portion 30, main-terminal-side fastening portions 40 (pair of fastening portions), an output terminal portion 50, an output-side fastening portion 60, a case 70, a first insulating portion 80, and a bonding wire Wb.

### Base Plate

The base plate 10 is a member having a flat plate shape.

The base plate 10 includes a front surface 10a and a back surface 10b positioned on a back side of this front surface 10a.

That is, the front surface 10a and the back surface 10b of the base plate 10 are back-to-back in a state of being parallel to each other.

The back surface 10b of the base plate 10 is fixed to, for example, the cooling device 6 (refer to FIG. 1) via a bonding material or the like (not illustrated).

Copper, for example, is adopted for the base plate 10 in the present embodiment.

Note that a metal such as aluminum may be adopted for the base plate 10.

### Circuit Board

The circuit board 20 includes an insulating plate 21, a front surface pattern 22, a power semiconductor element 23, and a back surface pattern 24.

The insulating plate 21 has a flat plate shape.

The insulating plate 21 includes a first surface 21a and a second surface 21b positioned on a back side of this first surface 21a.

That is, the first surface 21a and the second surface 21b of the insulating plate 21 are back-to-back in a state of being parallel to each other.

The back surface pattern 24, which is a pattern of copper foil or the like, is formed on the entire second surface 21b of the insulating plate 21.

The back surface pattern 24 is fixed to a center of the front surface 10a of the base plate 10 via a bonding material S.

The insulating plate 21 in the present embodiment is formed of, for example, an insulating material such as ceramic.

Note that, as the insulating material that forms the insulating plate 21, a paper phenol, a paper epoxy, a glass composite, a glass epoxy, a glass polyimide, a fluororesin, or the like can be adopted in addition to ceramic.

The front surface pattern 22 is a pattern of copper foil or the like formed on the first surface 21a of the insulating plate 21 and extending in a planar shape.

The front surface pattern 22 is formed by, for example, being fixed to the first surface 21a of the insulating plate 21 by joining or the like and then being etched or the like.

A plurality of the front surface patterns 22 are disposed on the first surface 21a of the insulating plate 21.

The plurality of front surface patterns 22 are disposed adjacent to each other with gaps interposed therebetween in an extending direction of the insulating plate 21.

In the present embodiment, a case in which three front surface patterns 22 are disposed on the first surface 21a will be described as an example.

Hereinafter, as illustrated in FIG. 2, the three front surface patterns 22 are referred to as a first front surface pattern 221, a second front surface pattern 222, and a third front surface pattern 223 for convenience of description.

The first front surface pattern 221 and the second front surface pattern 222 are patterns for exchanging input and output of a direct current with the capacitor 3, and correspond to an inlet section or an outlet section of a loop between P and N formed in the front surface patterns 22.

The external output conductor 5 for outputting the AC current converted by the power semiconductor element 23 to a load (not illustrated) provided outside the power conversion device 100 is connected to the third front surface pattern 223.

The power semiconductor element 23 is a circuit element that converts power by a switching operation of turning on and off a voltage or a current.

The power semiconductor element 23 is, for example, a switching element such as an insulated-gate bipolar transistor (IGBT) or a metal-oxide-semiconductor field-effect transistor (MOSFET).

In a case in which an IGBT is used, it is necessary to arrange in parallel a diode that causes a current to flow in a direction opposite to that of the IGBT. However, in the present embodiment, as an example, a case in which a MOSFET is applied to the power semiconductor is illustrated, and four power semiconductor elements 23 are connected to the front surface patterns 22 of the circuit board 20.

The four power semiconductor elements 23 in the present embodiment are constituted by two first power semiconductor elements 231 and two second power semiconductor elements 232.

The first power semiconductor elements 231 are connected to the first front surface pattern 221.

The second power semiconductor elements 232 are connected to the third front surface pattern 223.

In a case in which the power semiconductor element 23 is a MOSFET, the power semiconductor element 23 includes an input surface on which an input terminal (not illustrated) corresponding to a drain is formed, an output surface on which an output terminal (not illustrated) corresponding to a source is formed, and a gate corresponding to a control signal input terminal for controlling the switching of the power semiconductor element 23.

The input surface of each power semiconductor element 23 is electrically connected to the front surface pattern 22 via a bonding material.

The bonding wire Wb serving as a conducting wire is electrically connected to the output surface of each power semiconductor element 23 at one end.

The bonding wire Wb is formed of a metal such as aluminum.

That is, the front surface patterns 22 formed on the first surface 21a are electrically connected to each other by wire bonding.

The input surface of the first power semiconductor element 231 is connected to the first front surface pattern 221.

The bonding wire Wb connected to the output surface of the first power semiconductor element 231 at the one end is connected to the third front surface pattern 223 at the other end.

The input surface of the second power semiconductor element 232 is connected to the third front surface pattern 223.

The bonding wire Wb connected to the output surface of the second power semiconductor element 232 at the one end is connected to the second front surface pattern 222 at the other end.

DC power is input to the first power semiconductor element 231 via the first front surface pattern 221, and DC power is input to the second power semiconductor element 232 via the second front surface pattern 222 and the bonding wire Wb connecting this second front surface pattern 222 and the second power semiconductor element 232.

The first power semiconductor element 231 and the second power semiconductor element 232 perform a switching operation, thereby converting the DC power described above into AC power, and the AC power is output to the third front surface pattern 223.

A control signal generated by a control unit (not illustrated) provided outside the circuit board 20 is input to the power semiconductor element 23.

The power semiconductor element 23 performs switching in accordance with the control signal.

Note that, in a case in which the power semiconductor element 23 is an IGBT, the power semiconductor element 23 includes an input surface corresponding to a collector, an output surface corresponding to an emitter, and a gate corresponding to a control signal input terminal.

### Main Terminal Portion

As illustrated in FIG. 2 and FIG. 3, the main terminal portion 30 is an electric conductor (busbar) that exchanges DC power between the capacitor 3 and the circuit board 20.

The main terminal portion 30 is formed of a metal such as copper.

The main terminal portion 30 includes a first conductor 31 as a positive electrode and a second conductor 32 as a negative electrode.

The first conductor 31 and the second conductor 32 are disposed side by side with a gap G2 interposed therebetween.

In other words, the second conductor 32 is arranged side by side with the first conductor 31 with the gap G2 interposed therebetween.

The first conductor 31 includes a P terminal 310 connected to the positive-electrode-side terminal 3p of the capacitor 3, and a first connection portion 311 extending integrally with the P terminal 310 from the P terminal 310 and connected to the first front surface pattern 221.

Accordingly, the first conductor 31 includes the P terminal 310 at one end.

The P terminal 310 has a flat plate shape.

The P terminal 310 includes a first main surface 310a and a first back surface (not illustrated for convenience of illustration) facing the side opposite to this first main surface 310a.

In the P terminal 310, a fastening hole that extends through this P terminal 310 and opens to each of the first main surface 310a and the first back surface is formed.

The P terminal 310 is disposed with this fastening hole overlapping the hole h1 formed in the positive-electrode-side terminal 3p.

Accordingly, the P terminal 310 is disposed in a state of overlapping the positive-electrode-side terminal 3p.

The first back surface of the P terminal 310 faces the front surface 10a of the base plate 10.

The second conductor 32 includes an N terminal 320 connected to the negative-electrode-side terminal 3n of the capacitor 3, and a second connection portion 321 extending integrally with this N terminal 320 from the N terminal 320 and connected to the second front surface pattern 222.

Accordingly, the second conductor 32 includes the N terminal 320 at one end.

The N terminal 320 has a flat plate shape.

The N terminal 320 includes a second main surface 320a facing the same direction as the first main surface 310a of the P terminal 310, and a second back surface 320b facing the side opposite to this second main surface 320a.

As illustrated in FIG. 3, in the N terminal 320, a fastening hole h3 that extends through the N terminal 320 and opens to each of the second main surface 320a and the second back surface 320b is formed.

The N terminal 320 is disposed with this fastening hole h3 overlapping the hole h1 formed in the negative-electrode-side terminal 3n.

The second back surface 320b of the N terminal 320 faces the front surface 10a of the base plate 10.

### Main-Terminal-Side Fastening Portions

The main-terminal-side fastening portions 40 are a pair of fastening members that connect the P terminal 310 of the first conductor 31 and the positive-electrode-side terminal 3p of the capacitor 3, and the N terminal 320 of the second conductor 32 and the negative-electrode-side terminal 3n of the capacitor 3 to each other.

The main-terminal-side fastening portions 40 are formed of a metal such as copper.

The main-terminal-side fastening portions 40 in the present embodiment each include a bolt 41 including a head portion 410 and a thread portion 411 formed integrally with the head portion 410, and a nut 42.

Hereinafter, a configuration of, among the pair of main-terminal-side fastening portions 40, the main-terminal-side fastening portion 40 that connects the N terminal 320 and the negative-electrode-side terminal 3n will be described as illustrated in FIG. 3.

The main-terminal-side fastening portion 40 that connects the P terminal 310 and the positive-electrode-side terminal 3p has the same configuration as the main-terminal-side fastening portion 40 that connects the N terminal 320 and the negative-electrode-side terminal 3n, and thus a description thereof will be omitted.

The thread portion 411, in a state in which the head portion 410 is abutted against the negative-electrode-side terminal 3n, is inserted through the hole h1 of the negative-electrode-side terminal 3n and the hole h3 of the N terminal 320.

The nut 42, in a state of being screwed on the thread portion 411 of the bolt 41, is abutted against the N terminal 320 from the side opposite to the head portion 410 of the bolt 41.

The negative-electrode-side terminal 3n and the N terminal 320 are integrally fixed by being sandwiched between the bolt 41 and the nut 42.

### Output Terminal Portion

The output terminal portion 50 is an electrical conductor (busbar) that electrically connects the external output conductor 5 and the circuit board 20.

The output terminal portion 50 is formed of a metal such as copper.

The output terminal portion 50 is connected to the third front surface pattern 223 of the circuit board 20 at one end.

A fastening hole h4 is formed in the output terminal portion 50 at the other end.

The output terminal portion 50 is disposed with this fastening hole h4 overlapping the hole h2 formed in the external output conductor 5.

Accordingly, the output terminal portion 50 is disposed in a state of overlapping the external output conductor 5.

### Output-side Fastening Portion

The output-side fastening portion 60 is a fastening member that connects the external output conductor 5 and the output terminal portion 50.

The output-side fastening portion 60 is formed of a metal such as copper.

The output-side fastening portion 60 in the present embodiment includes a bolt 61 including a head portion 610 and a thread portion 611 formed integrally with the head portion 610, and a nut 62.

The thread portion 611, in a state in which the head portion 610 is abutted against the external output conductor 5, is inserted through the hole h2 of the external output conductor 5 and the hole h4 of the output terminal portion 50.

The nut 62, in a state of being screwed on the thread portion 611 of the bolt 61, is abutted against the output terminal portion 50 from the side opposite to the head portion 610 of the bolt 61.

The external output conductor 5 and the output terminal portion 50 are integrally fixed by being sandwiched between the bolt 61 and the nut 62.

### Case

The case 70 is a member that mechanically reinforces the main terminal portion 30 and the output terminal portion 50 in a state of being fixed to the front surface 10a of the base plate 10.

The case 70 is formed of, for example, a synthetic resin material (insulating material).

As the material forming the case 70 in the present embodiment, polyphenylene sulfide (PPS), for example, can be adopted.

Note that a synthetic resin material other than PPS may be adopted for the case 70.

The case 70 is fixed to the front surface 10a of the base plate 10 by, for example, an adhesive.

The case 70, in a state of covering the first conductor 31 and the second conductor 32 of the main terminal portion 30 as well as the output terminal portion 50 from the outer side, surrounds the circuit board 20 from the outer side.

As illustrated in FIG. 2 and FIG. 3, the case 70 forms a case surrounding the circuit board 20 in a direction along the front surface 10a of the base plate 10.

Accordingly, the case 70 defines a space in which the circuit board 20 is accommodated together with the base plate 10.

In the present embodiment, this space in which the circuit board 20 is accommodated is referred to as a potting space Rp.

Furthermore, the case 70 is formed with a first groove portion 71 defining a first accommodation space R1 (accommodation space) that accommodates the P terminal 310 of the first conductor 31, the N terminal 320 of the second conductor 32, and the pair of main-terminal-side fastening portions 40 therein, and a second groove portion 72 defining a second accommodation space R2 that accommodates the output terminal portion 50 and the output-side fastening portion 60 therein.

That is, the case 70 includes the first accommodation space R1 and the second accommodation space R2.

In the present embodiment, a portion of the first conductor 31 disposed in the first accommodation space R1 serves as the P terminal 310 described above, and a portion of the second conductor 32 disposed in the first accommodation space R1 serves as the N terminal 320 described above.

The potting space Rp described above and the first accommodation space R1 and the second accommodation space R2 formed in the case 70 open in a direction away from the front surface 10a.

The potting space Rp, the first accommodation space R1, and the second accommodation space R2 are isolated from each other by partition walls of the case 70 in an extending direction of the front surface 10a, and form spaces independent of one other.

Here, as illustrated in FIG. 3, a first accommodation groove 71g that can accommodate the thread portions 411 of the bolts 41 and the nuts 42 of the main-terminal-side fastening portions 40 is formed at a bottom surface 71b of the first groove portion 71.

The first back surface of the P terminal 310 of the first conductor 31 and the second back surface 320b of the N terminal 320 of the second conductor 32 abut against the bottom surface 71b of the first groove portion 71.

The thread portions 411 of the bolts 41 and the nuts 42 of the main-terminal-side fastening portions 40 abut against an inner surface of the first accommodation groove 71g.

A second accommodation groove 72g that can accommodate the thread portion 411 of the bolt 41 and the nut 42 of the output-side fastening portion 60 is formed at a bottom surface 72b of the second groove portion 72.

The output terminal portion 50 abuts against the bottom surface 72b of the second groove portion 72.

Further, the thread portion 411 of the bolt 41 and the nut 42 of the output-side fastening portion 60 abut against an inner surface of the second accommodation groove 72g.

### First Insulating Portion

The first insulating portion 80 is an insulating member disposed in the potting space Rp, in the first accommodation space R1, and in the second accommodation space R2.

The potting space Rp, the first accommodation space R1, and the second accommodation space R2 are filled with a liquid potting material from the outside (potting) to enclose members exposed in the respective spaces (potting space Rp, first accommodation space R1, second accommodation space R2).

The potting material with which each space is filled is cured over a predetermined time, and electrically insulates each member from the other members in the spaces and each member from the space outside the power module 400.

As the potting material in the present embodiment, a silicone gel or an epoxy resin, for example, can be used.

Note that a synthetic resin other than a silicone gel and an epoxy resin may be adopted as the potting material.

Accordingly, the first insulating portion 80 is formed of this potting material.

The first insulating portion 80 in the potting space Rp is disposed covering front surfaces of the circuit board 20, the bonding wire Wb, the first connection portion 311 of the main terminal portion 30, and the output terminal portion 50.

Accordingly, the first insulating portion 80 in the potting space Rp is disposed so that the gap G2 between the first connection portion 311 of the first conductor 31 and the second connection portion 321 of the second conductor 32 is filled therewith.

The first insulating portion 80 in the first accommodation space R1 covers, from the side opposite to the base plate 10, the first main surface 310a of the P terminal 310, the second main surface 320a of the N terminal 320, the positive-electrode-side terminal 3p and the negative-electrode-side terminal 3n of the connection conductor 3b, and the bolts 41 of the main-terminal-side fastening portions 40, in a state of the gap G2 between the P terminal 310 and the N terminal 320 being filled therewith.

The first insulating portion 80 in the second accommodation space R2 covers, from the side opposite to the base plate 10, the output terminal portion 50 and the bolt 41 of the output-side fastening portion 60.

Here, the first insulating portion formed by each space being filled with the potting material and curing the potting material includes top surfaces 81, 82, 83 that are liquid surfaces when filled.

The top surface 81 of the first insulating portion 80 disposed in the first space and the top surface 82 of the first insulating portion 80 disposed in the second space are positioned farther from the front surface 10a of the base plate 10 than the top surface 83 of the first insulating portion 80 disposed in the potting space Rp.

### Actions and Effects

According to the configuration described above, the first insulating portion 80 is disposed such that the gap G2 (clearance distance) in the main terminal portion 30 is filled therewith.

This makes it possible to suppress the discharge that occurs between the P terminal 310 and the N terminal 320 and the discharge that occurs between the N terminal 320 and the P terminal 310 as compared with a case in which the insulating material is not disposed between the P terminal 310 and the N terminal 320.

That is, the first insulating portion 80 is interposed between the P terminal 310 and the N terminal 320, making it possible to suppress dielectric breakdown between the P terminal 310 and the N terminal 320.

Accordingly, the gap G2 between the P terminal 310 and the N terminal 320 can be narrowed and, as a result, an increase in the size of the power module 400 can be suppressed.

Further, the first insulating portion 80 covers the first main surface 310a, the second main surface 320a, and the pair of main-terminal-side fastening portions 40 from the side opposite to the base plate 10, making it possible to suppress dielectric breakdown between the first main surface 310a and the second main surface 320a.

Further, when a current flows through the P terminal 310, the N terminal 320 is affected by a magnetic flux generated from the P terminal 310.

At this time, an induced current (eddy current) corresponding to a magnitude of a magnetic flux flows through the N terminal 320.

Similarly, when a current flows through the N terminal 320, the P terminal 310 is affected by a magnetic flux generated from the N terminal 320, and an induced current flows through the P terminal 310 as well.

These induced currents generate, from the P terminal 310 and the N terminal 320, respectively, magnetic fluxes that cancel out the magnetic fluxes generated in the P terminal 310 and the N terminal 320.

That is, by narrowing the spatial distance between the P terminal 310 and the N terminal 320, it is possible to effectively cancel out the magnetic fluxes.

Accordingly, a parasitic inductance generated in the main terminal portion 30 can be reduced.

Further, when a large current flows through the main terminal portion 30, the first conductor 31 and the second conductor 32 may generate heat and thermally expand in the extending direction of the front surface 10a of the base plate 10, for example.

According to the configuration described above, since the first insulating portion 80 is interposed between the P terminal 310 and the N terminal 320, even if the gap G2 narrows with the thermal expansion of the P terminal 310 and the N terminal 320, dielectric breakdown does not occur between the P terminal 310 and the N terminal 320.

### Second Embodiment

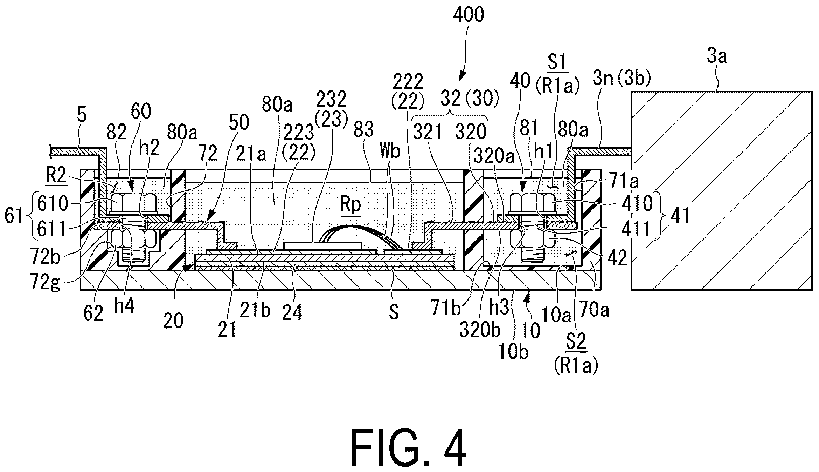

Next, a second embodiment of the power conversion device according to the present invention will be described with reference to FIG. 4.

Note that, in the second embodiment described below, the same components as those in the first embodiment described above are denoted by the same reference signs in the drawings, and description thereof will be omitted.

In the second embodiment, the configurations of the case of the power module and the first insulating portion differ from the configurations described in the first embodiment.

### Case

A case 70a is a member that mechanically reinforces the main terminal portion 30 and the output terminal portion 50 in a state of being fixed to the front surface 10a of the base plate 10.

The case 70a is formed with a first groove portion 71a defining a first accommodation space R1a (accommodation space) that accommodates the P terminal 310 of the first conductor 31, the N terminal 320 of the second conductor 32, and the pair of main-terminal-side fastening portions 40 therein, and the second groove portion 72 defining the second accommodation space R2 that accommodates the output terminal portion 50 and the output-side fastening portion 60 therein.

The first accommodation space R1a in the present embodiment is partitioned into a main-surface-side space S1 and a back-surface-side space S2 with the P terminal 310 and the N terminal 320 of the main terminal portion 30 as a boundary.

The main-surface-side space S1 and the back-surface-side space S2 communicate with each other through the gap G2 between the P terminal 310 and the N terminal 320 and an area between the P terminal 310 and the N terminal 320 and an inner surface of the first groove portion 71a.

Accordingly, when the first accommodation space R1a is filled with the potting material, the potting material spreads to the back-surface-side space S2 through the locations described above where the main-surface-side space S1 and the back-surface-side space S2 are in communication with each other.

The thread portions 411 of the bolts 41 and the nuts 42 of the main-terminal-side fastening portions 40 are disposed in the back-surface-side space S2.

In the present embodiment, the first back surface of the P terminal 310, the second back surface 320b of the N terminal 320, the thread portions 411 of the bolts 41, and the nuts 42 do not abut against the inner surface of the first groove portion 71a.

### First Insulating Portion

A first insulating portion 80a is an insulating member disposed in the potting space Rp, the first accommodation space R1a, and the second accommodation space R2.

The first insulating portion 80a in the first accommodation space R1a covers, from the outer side, the first main surface 310a and the first back surface of the P terminal 310, the second main surface 320a and the second back surface 320b of the N terminal 320, the positive-electrode-side terminal 3p and the negative-electrode-side terminal 3n of the connection conductor 3b, and the bolts 41 and the nuts 42 of the main-terminal-side fastening portions 40, in a state of the gap G2 between the first conductor 31 and the second conductor 32 being filled therewith.

### Actions and Effects

According to the configuration described above, the first insulating portion 80a covers the first back surface of the P terminal 310, the second back surface 320b of the N terminal 320, and the pair of main-terminal-side fastening portions 40 from the base plate 10 side as well, thereby insulating the P terminal 310 and the N terminal 320 from each other in the first accommodation space R1a.

That is, the P terminal 310 and the N terminal 320 are solid-insulated by the first insulating portion 80a.

Accordingly, as compared with the configuration described in the first embodiment, it is possible to further suppress conduction between the P terminal 310 and the N terminal 320.

That is, it is possible to further narrow the gap G2 between the P terminal 310 and the N terminal 320.

### Third Embodiment

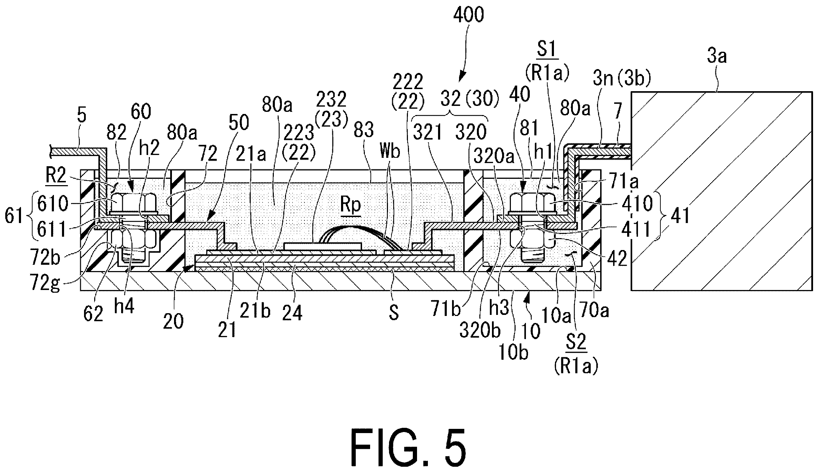

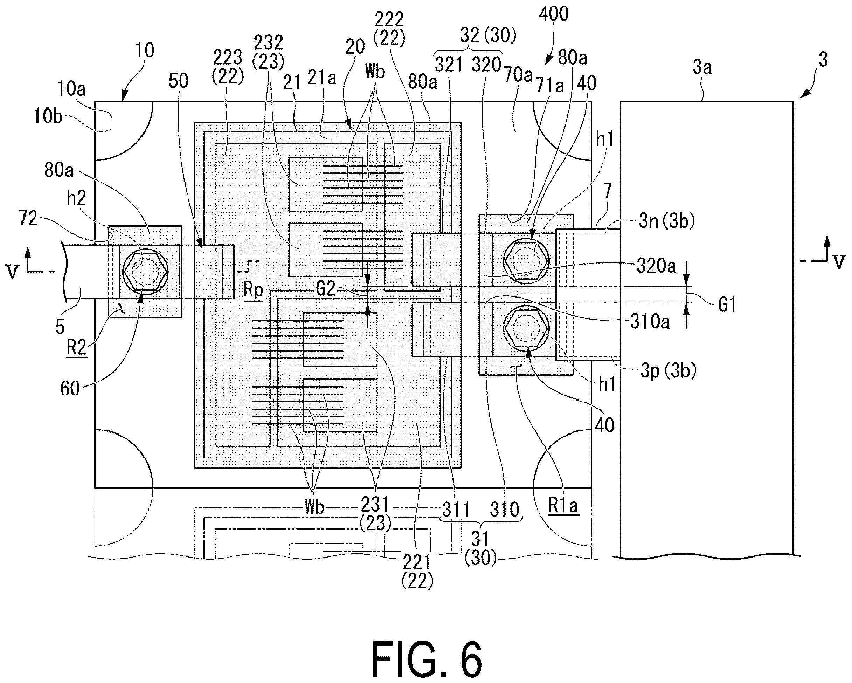

Next, a third embodiment of the power conversion device according to the present invention will be described with reference to FIG. 5 and FIG. 6.

Note that, in the third embodiment described below, the same components as those in the first embodiment and the second embodiment described above are denoted by the same reference signs in the drawings, and description thereof will be omitted.

In the third embodiment, the power conversion device further includes a second insulating portion.

### Second Insulating Portion

A second insulating portion 7 is an insulating member formed integrally with the positive-electrode-side terminal 3p and the negative-electrode-side terminal 3n so as to extend integrally with the first insulating portion 80a from the first insulating portion 80a toward the main body portion 3a of the capacitor 3.

The second insulating portion 7 covers the positive-electrode-side terminal 3p and the negative-electrode-side terminal 3n from the outer side in a state of the gap G1 between the positive-electrode-side terminal 3p and the negative-electrode-side terminal 3n being filled therewith.

The second insulating portion 7 in the present embodiment is formed of a synthetic resin material different from that of the first insulating portion 80a.

### Actions and Effects

According to the configuration described above, the positive-electrode-side terminal 3p and the negative-electrode-side terminal 3n of the capacitor 3 are insulated from each other.

That is, the positive-electrode-side terminal 3p and the negative-electrode-side terminal 3n are solid-insulated by the second insulating portion 7.

That is, it is possible to suppress dielectric breakdown between the positive-electrode-side terminal 3p and the negative-electrode-side terminal 3n.

Accordingly, the gap G1 between the positive-electrode-side terminal 3p and the negative-electrode-side terminal 3n can be narrowed and, as a result, an increase in the size of the power conversion device 100 can be suppressed.

### Other Embodiments

Although embodiments of the present invention have been described in detail with reference to the drawings, specific configurations are not limited to the configurations of the embodiments, and additions, omissions, substitutions, and other modifications of the configurations can be made without departing from the scope of the appended claims.

Note that, in the embodiments described above, the inverter is described as an example of the power conversion device 100. However, the power conversion device 100 is not limited to the inverter.

The power conversion device 100 may be, for example, a device that performs power conversion by the power semiconductor element 23, such as a converter or a combination of an inverter and a converter.

In a case in which the power conversion device 100 is a converter, a configuration may be adopted in which an AC voltage is input from an external input power supply (not illustrated) to the external output conductor 5, the power semiconductor element 23 of the circuit board 20 converts the AC voltage into a DC voltage, and the DC voltage from the power semiconductor element 23 is output to outside the power conversion device through the main terminal portion 30 and the connection conductor 3b.

Further, the configuration of the third embodiment described with reference to FIG. 5 and FIG. 6 may be applied to the first embodiment.

That is, the power conversion device 100 described in the first embodiment may further include the second insulating portion 7 described in the third embodiment.

### Supplementary Notes

The advantages of the power module and the power conversion device described in each embodiment are understood as follows:

The subject-matter of claim 1 makes it possible to suppress the discharge that occurs between the P terminal 310 and the N terminal 320 as comparison with a case in which the insulating material is not disposed between the P terminal 310 and the N terminal 320.

That is, the first insulating portion 80, 80a is interposed between the P terminal 310 and the N terminal 320, making it possible to suppress dielectric breakdown between the P terminal 310 and the N terminal 320.

Accordingly, it is possible to narrow the gap G2 between the P terminal 310 and the N terminal 320.

In the power module of claim 2, the P terminal 310 and the N terminal 320 are insulated from each other in the accommodation space (first accommodation space R1, R1a).

That is, the P terminal 310 and the N terminal 320 are solid-insulated by the first insulating portion 80a.

Accordingly, it is possible to further suppress conduction between the P terminal 310 and the N terminal 320.

The subject-matter of claim 3 makes it possible to suppress conduction between the positive-electrode-side terminal 3p and the negative-electrode-side terminal 3n.

Accordingly, it is possible to narrow the gap between the positive-electrode-side terminal 3p connected to the P terminal 310 and the negative-electrode-side terminal 3n connected to the N terminal 320.

### Industrial Applicability

According to the present invention, it is possible to provide a power module and a power conversion device in which the creepage distance between terminals is secured without an increase in size.

### Reference Signs List

1 Casing
1a Input-side side surface
1b Output-side side surface
2 External input conductor
3 Capacitor
3a Main body portion
3b Connection conductor
3n Negative-electrode-side terminal
3p Positive-electrode-side terminal
4 Power conversion unit
5 External output conductor
6 Cooling device
7 Second insulating portion
10 Base plate
10a Front surface
10b Back surface
20 Circuit board
21 Insulating plate
21a First surface
21b Second surface
22 Front surface pattern
23 Power semiconductor element
24 Back surface pattern
30 Main terminal portion
31 First conductor
32 Second conductor
40 Main-terminal-side fastening portion
41, 61 Bolt
42, 62 Nut
50 Output terminal portion
60 Output-side fastening portion
70, 70a Case
71, 71a First groove portion
71b, 72b Bottom surface
71g First accommodation groove
72 Second groove portion
72g Second accommodation groove
80, 80a First insulating portion
81, 82, 83 Top surface
100 Power conversion device
221 First front surface pattern
222 Second front surface pattern
223 Third front surface pattern
231 First power semiconductor element
232 Second power semiconductor element
310 P terminal
310a First main surface
311 First connection portion
320 N terminal
320a Second main surface
320b Second back surface
321 Second connection portion
400 Power module
410, 610 Head portion
411, 611 Thread portion
G1, G2 Gap
h1, h2, h3, h4 Hole
R1, R1a First accommodation space
R2 Second accommodation space
Rp Potting space
S Bonding material
S1 Main-surface-side space
S2 Back-surface-side space Wb Bonding wire

## Claims

1. A power module (400) comprising:
a main terminal portion (30) including
a first conductor (31) including a P terminal (310) at one end of the first conductor, the P terminal including a first main surface (310a) and a first back surface facing a side opposite to the first main surface, and
a second conductor (32) including an N terminal (320) at one end of the second conductor, the N terminal including a second main surface (320a) facing a direction identical to a direction in which the first main surface faces and a second back surface (320b) facing a side opposite to the second main surface, the second conductor being connected to a capacitor (3) together with the first conductor and being arranged side by side with the first conductor with a gap (G2) interposed between the second conductor and the first conductor;
a circuit board (20) including a power semiconductor element (23) configured to convert a DC voltage from the main terminal portion into an AC voltage;
an output terminal portion (50) configured to output an AC voltage from the power semiconductor element;
a pair of fastening portions (40) connecting the P terminal and a positive-electrode-side terminal (3p) of the capacitor to each other and connecting the N terminal and a negative-electrode-side terminal (3n) of the capacitor to each other;
a base plate (10) to which the circuit board is fixed, the base plate including a front surface (10a) facing the first back surface and the second back surface;
a case (70, 70a) fixed to the front surface of the base plate and including an accommodation space (R1 ; S1, S2) accommodating the P terminal, the N terminal, and the pair of fastening portions; and
a first insulating portion (80 ; 80a) disposed in the accommodation space and covering the first main surface (310a), the second main surface (320a), and the pair of fastening portions (40) from a side opposite to the base plate (10), in a state of the gap (G2) being filled with the first insulating portion (80, 80a).

2. The power module according to claim 1,
wherein the first insulating portion (80a) further covers the first back surface, the second back surface, and the pair of fastening portions from the base plate side.

3. A power conversion device comprising:
the power module (400) according to claim 1 or 2;
the capacitor; and
a second insulating portion (7) formed integrally with the positive-electrode-side terminal (3p) and the negative-electrode-side terminal (3n) so as to extend from the first insulating portion (80, 80a), and covering the positive-electrode-side terminal and the negative-electrode-side terminal from an outer side.

## Patentansprüche

1. Leistungsmodul (400) umfassend:
einen Hauptanschlussabschnitt (30) beinhaltend
einen ersten Leiter (31), der einen P-Anschluss (310) an einem Ende des ersten Leiters beinhaltet, wobei der P-Anschluss eine erste Hauptfläche bzw. - oberfläche (310a) und eine erste Rückfläche bzw. -oberfläche beinhaltet, die einer Seite gegenüberliegend bzw. entgegengesetzt zu der ersten Hauptfläche zugewandt ist, und
einen zweiten Leiter (32), der einen N-Anschluss (320) an einem Ende des zweiten Leiters beinhaltet, wobei der N-Anschluss eine zweite Hauptfläche bzw. -oberfläche (320a), die einer Richtung zugewandt ist, die identisch mit einer Richtung ist, in welche die erste Hauptfläche gewandt ist, und eine zweite Rückfläche bzw. -oberfläche (320b) beinhaltet, die einer Seite gegenüberliegend bzw. entgegengesetzt zu der zweiten Hauptfläche zugewandt ist, wobei der zweite Leiter mit einem Kondensator (3) zusammen mit dem ersten Leiter verbunden ist und Seite an Seite mit dem ersten Leiter angeordnet ist, wobei ein Spalt (G2) zwischen dem zweiten Leiter und dem ersten Leiter angeordnet bzw. bereitgestellt ist;
eine Leiterplatte (20), die ein Leistungshalbleiterelement (23) beinhaltet, das konfiguriert ist, eine DC-Spannung von dem Hauptanschlussabschnitt in eine AC-Spannung umzuwandeln;
einen Ausgangsanschlussabschnitt (50), der konfiguriert ist, eine AC-Spannung von dem Leistungshalbleiterelement auszugeben;
ein Paar Befestigungsabschnitte (40), die den P-Anschluss und einen Positive-Elektrode-Seite-Anschluss (3p) des Kondensators miteinander verbinden und den N-Anschluss und einen Negative-Elektrode-Seite-Anschluss (3n) des Kondensators miteinander verbinden;
eine Basisplatte (10), an der die Leiterplatte befestigt ist, wobei die Basisplatte eine Frontfläche bzw. -oberfläche (10a) beinhaltet, die der ersten Rückfläche und der zweiten Rückfläche zugewandt ist;
ein Gehäuse (70, 70a), das an der Frontfläche der Basisplatte befestigt ist und einen Aufnahmeraum (R1; S1, S2) beinhaltet, der den P-Anschluss, den N-Anschluss und das Paar Befestigungsabschnitte aufnimmt; und
einen ersten Isolierabschnitt (80; 80a), der in dem Aufnahmeraum angeordnet ist und die erste Hauptfläche (310a), die zweite Hauptfläche (320a) und das Paar Befestigungsabschnitte (40) von einer Seite gegenüberliegend bzw. entgegengesetzt zu der der Basisplatte (10) abdeckt, und zwar in einem Zustand, in dem der Spalt (G2) mit dem ersten Isolierabschnitt (80, 80a) ausgefüllt ist.

2. Leistungsmodul nach Anspruch 1,
wobei der erste Isolierabschnitt (80a) ferner die erste Rückfläche, die zweite Rückfläche und das Paar Befestigungsabschnitte von der Seite der Basisplatte her abdeckt.

3. Leistungsumwandlungsvorrichtung, umfassend:
das Leistungsmodul (400) nach Anspruch 1 oder 2;
den Kondensator; und
einen zweiten Isolierabschnitt (7), der integral mit dem Positive-Elektrode-Seite-Anschluss (3p) und dem Negative-Elektrode-Seite-Anschluss (3n) gebildet ist, um sich von dem ersten Isolierabschnitt (80, 80a) zu erstrecken, und der den Positive-Elektrode-Seite-Anschluss und den Negative-Elektrode-Seite-Anschluss von einer Außenseite abdeckt.

## Revendications

1. Module de puissance (400) comprenant :
une partie borne principale (30) comportant un premier conducteur (31) comportant une borne P (310) à une extrémité du premier conducteur, la borne P comportant une première surface principale (310a) et une première surface arrière faisant face à un côté opposé à la première surface principale, et
un second conducteur (32) comportant une borne N (320) à une extrémité du second conducteur, la borne N comportant une seconde surface principale (320a) faisant face à une direction identique à une direction dans laquelle la première surface principale est orientée et une seconde surface arrière (320b) faisant face à un côté opposé à la seconde surface principale, le second conducteur étant connecté à un condensateur (3) conjointement avec le premier conducteur et étant agencé côte à côte avec le premier conducteur avec un espace (G2) interposé entre le second conducteur et le premier conducteur ;
une carte de circuit imprimé (20) comportant un élément semi-conducteur de puissance (23) configuré pour convertir une tension CC provenant de la partie borne principale en tension CA ;
une partie borne de sortie (50) configurée pour émettre une tension CA à partir de l'élément semi-conducteur de puissance ;
une paire de parties de fixation (40) connectant la borne P et une borne côté électrode positive (3p) du condensateur l'une à l'autre et connectant la borne N et une borne côté électrode négative (3n) du condensateur l'une à l'autre ;
une plaque de base (10) à laquelle la carte de circuit imprimé est fixée, la plaque de base comportant une surface avant (10a) faisant face à la première surface arrière et à la seconde surface arrière ;
un boîtier (70, 70a) fixé à la surface avant de la plaque de base et comportant un espace de réception (R1 ; S1, S2) recevant la borne P, la borne N et la paire de parties de fixation ; et
une première partie isolante (80 ; 80a) disposée dans l'espace de réception et recouvrant la première surface principale (310a), la seconde surface principale (320a) et la paire de parties de fixation (40) à partir d'un côté opposé à la plaque de base (10), dans un état où l'espace (G2) est rempli de la première partie isolante (80, 80a).

2. Module de puissance selon la revendication 1,
dans lequel la première partie isolante (80a) recouvre en outre la première surface arrière, la seconde surface arrière et la paire de parties de fixation à partir du côté plaque de base.

3. Dispositif de conversion de puissance comprenant :
le module de puissance (400) selon la revendication 1 ou 2 ;
le condensateur ; et
une seconde partie isolante (7) formée d'un seul tenant avec la borne côté électrode positive (3p) et la borne côté électrode négative (3n) de manière à s'étendre à partir de la première partie isolante (80, 80a), et recouvrant la borne côté électrode positive et la borne côté électrode négative à partir d'un côté extérieur.
